# EUROPÄISCHE PATENTSCHRIFT

(11) **EP 0 783 180 B1**
(45) Veröffentlichungstag und Bekanntmachung des Hinweises auf die Patenterteilung: **02.11.2005**
(21) Anmeldenummer: 96119226.7
(22) Anmeldetag: 29.11.1996
(51) Int. Cl.: H01L 27/115, H01L 21/8247

(54) **Elektrisch programmierbare Speicherzellenanordnung und Verfahren zu deren Herstellung**
Electrically programmable memory cell arrangement and process for making the same
Ensemble de cellules mémoire électriquement programmable et procédé de fabrication

(30) Priorität: 08.01.1996 DE 19600422
(43) Veröffentlichungstag der Anmeldung: 09.07.1997
(73) Patentinhaber: Infineon Technologies AG, 81669 München (DE)
(72) Erfinder: Hofmann, Franz, Dr., 80995 München (DE); Risch, Lothar, Dr., 85579 Neubiberg (DE); Krautschneider, Wolfgang, Dr., 83104 Hohenthann (DE); Reisinger, Hans, Dr., 82031 Grünwald (DE)
(74) Vertreter: Epping - Hermann - Fischer

(56) Entgegenhaltungen:
- EP-A- 0 673 070
- DE-A- 3 032 364
- US-A- 4 047 974
- US-A- 4 814 840
- US-A- 5 306 941

## Beschreibung

Elektrisch programmierbare Speicherzellenanordnung und Verfahren zu deren Herstellung.

Für viele elektronische Systeme werden Speicher benötigt, in die Daten fest eingeschrieben sind. Derartige Speicher werden unter anderem als Festwertspeicher, Lesespeicher oder Read-Only-Memory bezeichnet.

Für sehr große Datenmengen werden als Lesespeicher vielfach Kunststoffscheiben verwendet, die mit Aluminium beschichtet sind. In der Beschichtung weisen diese Kunststoffscheiben zweierlei punktartige Vertiefungen auf, die den logischen Werten Null und Eins zugeordnet werden. In der Anordnung dieser Vertiefungen ist die Information digital abgespeichert. Derartige Scheiben werden als Compaktdisc bezeichnet und sind zur digitalen Abspeicherung von Musik verbreitet.

Zum Lesen der auf einer Compaktdisc gespeicherten Daten wird ein Lesegerät verwendet, in dem die Scheibe mechanisch rotiert. Die punktartigen Vertiefungen werden über eine Laserdiode und eine Photozelle abgetastet. Typische Abtastraten sind dabei 2 x 40 kHz. Auf einer Compaktdisc können fünf GBits Informationen gespeichert werden.

Das Lesegerät weist bewegte Teile auf, die mechanischem Verschleiß unterworfen sind, die vergleichsweise viel Volumen benötigen und die nur einen langsamen Datenzugriff erlauben. Das Lesegerät ist darüber hinaus empfindlich gegen Erschütterungen und daher in mobilen Systemen nur begrenzt einsetzbar.

Zur Speicherung kleinerer Datenmengen sind Festwertspeicher auf Halbleiterbasis bekannt. Vielfach werden diese als planare integrierte Siliziumschaltung realisiert, in der MOS-Transistoren verwendet werden. Die MOS-Transistoren werden jeweils über die Gateelektrode, die mit der Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend wird die gespeicherte Information zugeordnet. Technisch wird die Speicherung der Information meist dadurch bewirkt, daß die MOS-Transistoren durch unterschiedliche Implantation im Kanalgebiet unterschiedliche Einsatzspannungen aufweisen.

Diese Speicher auf Halbleiterbasis erlauben einen wahlfreien Zugriff auf die gespeicherte Information. Die zum Lesen der Information erforderliche elektrische Leistung ist deutlich kleiner als bei einem Lesegerät mit einem mechanischen Laufwerk. Da zum Lesen der Information kein mechanisches Laufwerk erforderlich ist, entfällt der mechanische Verschleiß und die Empfindlichkeit gegenüber Erschütterungen. Festwertspeicher auf Halbleiterbasis sind daher auch für mobile Systeme einsetzbar.

Die beschriebenen Siliziumspeicher weisen einen planaren Aufbau auf. Damit wird pro Speicherzelle ein minimaler Flächenbedarf erforderlich, der bei etwa 6 bis 8 F² liegt, wobei F die in der jeweiligen Technologie kleinste herstellbare Strukturgröße ist. Planare Siliziumspeicher sind damit in einer 1 µm-Technologie auf Speicherdichten um 0,14 Bit pro µm² begrenzt.

Es ist bekannt, bei planaren Siliziumspeichern die Speicherdichte dadurch zu erhöhen, daß die MOS-Transistoren zeilenweise angeordnet sind. In jeder Zeile sind die MOS-Transistoren in Reihe verschaltet. Durch zeilenweises Ansteuern im Sinne einer "NAND"-Architektur werden die MOS-Transistoren ausgelesen. Dazu sind pro Zeile nur zwei Anschlüsse erforderlich, zwischen denen die in der Zeile angeordneten MOS-Transistoren in Reihe verschaltet sind. Miteinander verbundene Source/Drain-Gebiete benachbarter MOS-Transistoren können dann als zusammenhängendes dotiertes Gebiet realisiert sein. Dadurch kann der Flächenbedarf pro Speicherzelle auf theoretisch 4 F² (F: in der jeweiligen Technologie kleinste herstellbare Strukturgröße) reduziert werden. Eine solche Speicherzellenanordnung ist zum Beispiel aus H. Kawagoe und N. Tsuji in IEEE J. Solid-State Circuits, vol. SC-11, p. 360, 1976, bekannt.

Die Programmierung der beschriebenen Speicherzellenanordnungen erfolgt bei der Herstellung. Für viele Anwendungen werden jedoch Speicher benötigt, in die Daten durch elektrische Programmierung eingeschrieben werden können. In elektrisch programmierbaren Speicherzellenanordnungen wird die Speicherung der Information meist dadurch bewirkt, daß zwischen dem Gate und dem Kanalgebiet der MOS-Transistoren ein floatendes Gate, das mit einer elektrischen Ladung beaufschlagt werden kann, oder als Gatedielektrikum eine Doppelschicht aus SiO₂ und Si₃N₄, an deren Grenzfläche elektrische Ladungsträger an Haftstellen festgehalten werden können, vorgesehen ist. Die Einsatzspannung des MOS-Transistors ist abhängig von der auf dem floatenden Gate bzw. den Haftstellen befindlichen Ladung. Diese Eigenschaft wird zur elektrischen Programmierung ausgenutzt (siehe zum Beispiel S. M. Sze, Semiconductor Devices, John Wiley, Seite 486 bis 490).

Aus der EP 0 673 070 A2 war eine EEPROM-Anordnung bekannt, bei der als Speicherzellen in Reihe verschaltete MOS Transistoren verwendet werden, die jeweils alternierend am Boden eines Grabens und zwischen benachbarten Gräben an der Oberfläche eines Substrats angeordnet sind. Die MOS-Transistoren weisen jeweils Floating Gate und Control Gate auf. Die Speicherzellenanordnung ist als NAND-Speicher verschaltet.

Die DE 30 32 364 A1 beschreibt einen elektrisch programmierbaren Halbleiterfestwertspeicher, in dem als Speicherzellen planare MOS-Transistoren mit einer Mehrfachschicht als Gatedielektrikum verwendet werden. Als Gatedielektrikum wird insbesondere eine Dreifachschicht aus Siliziumoxid/Siliziumnitrid/Siliziumoxid verwendet.

Der Erfindung liegt das Problem zugrunde, eine elektrisch programmierbare Speicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzellenanordnung angegeben werden.

Dieses Problem wird gelöst durch eine Speicherzellenanordnung gemäß Anspruch 1 sowie durch ein Verfahren zu deren Herstellung gemäß Anspruch 8. Weitere Ausgestaltungen der Erfindung gehen aus den übrigen Ansprüchen hervor. In der erfindungsgemäßen Speicherzellenanordnung sind Speicherzellen jeweils in im wesentlichen parallel verlaufenden Zeilen in einer Hauptfläche eines Halbleitersubstrats angeordnet. In der Hauptfläche des Halbleitersubstrats sind Längsgräben vorgesehen. Die Längsgräben verlaufen im wesentlichen parallel zu den Zeilen. Sie sind mindestens so lang wie die Zeilen. Die Zeilen sind jeweils abwechselnd zwischen benachbarten Längsgräben und auf dem Boden der Längsgräben angeordnet. Die Hauptfläche des Halbleitersubstrats ist durch die Längsgräben strukturiert. Jede zweite der Zeilen ist am Boden der Längsgräben angeordnet, die dazwischen angeordneten Zeilen sind auf dem die Längsgräben begrenzenden Material angeordnet.

Die MOS-Transistoren weisen ein Gatedielektrikum aus einem Material mit Haftstellen auf. Haftstellen, englisch traps, haben die Eigenschaften Ladungsträger, speziell Elektronen, einzufangen. Zur elektrischen Programmierung werden die MOS-Transistoren so beschaltet, daß der zu speichernden Information entsprechende Ladungsträger in das Gatedielektrikum gelangen und von den Haftstellen festgehalten werden. Da die Ladungsträger in den Haftstellen gefangen sind, ist die Information dauerhaft gespeichert. Die programmierte Speicherzellenanordnung stellt daher eine Festwert-Speicherzellenanordnung dar. Die Programmierung kann sowohl durch Fowler-Nordheim-Tunneln als auch durch Hot-Electron-Injection erfolgen. Durch Umkehr der Polaritäten beim Fowler-Nordheim-Tunneln können Ladungsträger aus den Haftstellen entfernt werden, so daß die Programmierung der Speicherzellenanordnung geändert wird.

Zur Abspeicherung von Daten in digitaler Form werden die MOS-Transistoren so programmiert, daß sie zwei unterschiedliche Schwellenspannungen aufweisen. Soll die Speicherzellenanordnung für Mehrwertlogik eingesetzt werden, so wird das Gatedielektrikum durch entsprechende Spannungs- und Zeitbedingungen bei der Programmierung so mit unterschiedlichen Ladungsmengen beaufschlagt, daß die MOS-Transistoren je nach eingespeicherter Information mehr als zwei unterschiedliche Schwellenspannungen aufweisen.

Das Gatedielektrikum ist gemäß einer Ausführungsform der Erfindung als Mehrfachschicht ausgebildet, in der mindestens eine Schicht vorgesehen ist, die im Vergleich mit mindestens einer weiteren Schicht in der Mehrfachschicht einen erhöhten Ladungsträgereinfangquerschnitt aufweist. Die Haftstellen sind an der Grenzfläche zwischen beiden Schichten lokalisiert. Vorzugsweise umfaßt die dielektrische Mehrfachschicht eine SiO₂-Schicht, eine Si₃N₄-Schicht und eine SiO₂-Schicht (sogenanntes ONO). Alternativ kann das Gatedielektrikum als Mehrfachschicht aus anderen Materialien, wobei die Schicht mit dem erhöhten Ladungsträgereinfangquerschnitt zum Beispiel aus Si₃N₄, Ta₂O₅, Al₂O₃ oder aus TiO₂ besteht und die benachbarte Schicht aus SiO₂, Si₃N₄ oder Al₂O₃ bestehen. Ferner kann die Mehrfachschicht mehr oder weniger als drei Schichten umfassen.

Alternativ kann das Gatedielektrikum eine dielektrische Schicht, zum Beispiel aus SiO₂, umfassen, in die Fremdatome , zum Beispiel W, Pt, Cr, Ni, Pd, oder Ir eingelagert sind. Die eingelagerten Fremdatome können durch Implantation, durch Zugabe bei einer Oxidation oder durch Diffusion eingebracht werden. Die eingelagerten Fremdatome bilden in diesem Fall die Haftstellen.

Benachbarte Zeilen sind durch eine Isolationsstruktur gegeneinander isoliert. Die Isolationsstruktur isoliert benachbarte Zeilen in vertikaler Richtung. Es liegt im Rahmen der Erfindung, die Isolationsstruktur durch entlang den Seitenwänden der Längsgräben angeordnete, isolierende Spacer und jeweils zwischen benachbarten Längsgräben im Halbleitersubstrat angeordnete, dotierte Schichten, die die Ausbildung leitender Kanäle im Halbleitersubstrat zwischen benachbarten Zeilen verhindern, sogenannte Channel-Stop-Schichten, auszubilden.

Die dotierten Schichten sind vorzugsweise in dem Material des Halbleitersubstrats, das jeweils zwischen benachbarten Längsgräben angeordnet ist, ausgebildet und weisen eine Tiefe im Halbleitersubstrat auf, die geringer als die Tiefe der Längsgräben ist. Diese Isolation benötigt zwischen benachbarten Zeilen keine Fläche. Parallel zur Hauptfläche des Halbleitersubstrats sind benachbarte Zeilen unmittelbar zueinander benachbart. Senkrecht zur Hauptfläche des Halbleitersubstrats weisen benachbarte Zeilen einen Abstand entsprechend der Tiefe der Längsgräben auf.

Vorzugsweise sind die MOS-Transistoren von entlang einer Zeile angeordneten Speicherzellen in Reihe verschaltet. Miteinander verbundene Source/Drain-Gebiete von entlang einer Zeile benachbarten MOS-Transistoren sind dabei als zusammenhängendes dotiertes Gebiet ausgebildet. Jede Zeile weist zwei Anschlüsse auf, zwischen denen in der Zeile angeordnete MOS-Transistoren in Reihe verschaltet sind. Über diese Anschlüsse können die in der jeweiligen Zeile befindlichen MOS-Transistoren im Sinne einer "NAND"-Architektur angesteuert werden.

Vorzugsweise wird die erfindungsgemäße Speicherzellenanordnung mit einer Isolationsstruktur, die isolierende Spacer und dotierte Schichten, die die Ausbildung leitender Kanäle im Halbleitersubstrat zwischen benachbarten Zeilen verhindern, umfaßt, sowie mit in jeder Zeile in Reihe verschalteten MOS-Transistoren, in denen jeweils miteinander verbundene Source/Drain-Gebiete als zusammenhängendes dotiertes Gebiet im Halbleitersubstrat ausgebildet sind, realisiert. Werden in dieser Ausführungsform die Breite der Längsgräben, der Abstand benachbarter Längsgräben, die Ausdehnung der zusammenhängenden dotierten Gebiete und die Breite der Wortleitungen entsprechend einem in der jeweiligen Technologie minimalen Strukturgröße F ausgebildet, so beträgt der Flächenbedarf pro Speicherzelle 2 F². Unter Zugrundelegung einer Technologie mit einer minimalen Strukturbreite F von 0,4 µm ist damit eine Speicherdichte von 6,25 Bit/µm² erzielbar.

Die Herstellung der erfindungsgemäßen Speicherzellenanordnung erfolgt unter Einsatz selbstjustierender Prozeßschritte, so daß der Platzbedarf pro Speicherzelle reduziert werden kann.

Zur Herstellung der Speicherzellenanordnung werden zunächst im wesentlichen parallel verlaufende Längsgräben geätzt. Nach Erzeugung eines Gatedielektrikums aus einem Material mit Haftstellen für alle MOS-Transistoren werden quer zu den Zeilen verlaufende Wortleitungen erzeugt, die jeweils Gateelektroden von entlang unterschiedlichen Zeilen angeordneten MOS-Transistoren bilden. Schließlich wird eine Source/Drain-Implantation durchgeführt, bei der die Wortleitungen als Maske verwendet werden und bei der gleichzeitig die Source/Drain-Gebiete für die MOS-Transistoren, die am Boden der Längsgräben angeordnet sind und für die MOS-Transistoren, die zwischen benachbarten Langsgräben angeordnet sind, gebildet werden.

Vorzugsweise werden die Längsgräben unter Verwendung einer SiO₂-enthaltenden Grabenmaske als Ätzmaske geätzt.

Das Gatedielektrikum wird gemäß einer Ausführungsform der Erfindung als Mehrfachschicht mit mindestens einer Schicht, die im Vergleich mit mindestens einer weiteren Schicht einen erhöhten Ladungsträgereinfangsquerschnitt aufweist, gebildet. Alternativ wird das Gatedielektrikum als dielektrische Schicht mit eingelagerten Fremdatomen gebildet, wobei die eingelagerten Fremdatome im Vergleich mit der dielektrischen Schicht einen erhöhten Ladungsträgereinfangsquerschnitt aufweisen.

Im folgenden wird die Erfindung anhand eines Ausführungsbeispiels und der Figuren näher erläutert.
- Figur 1: zeigt ein Siliziumsubstrat nach Bildung einer Channel-Stop-Schicht.
- Figur 2: zeigt das Siliziumsubstrat nach einer Grabenätzung.
- Figur 3: zeigt das Siliziumsubstrat nach Bildung von Wortleitungen.
- Figur 4: zeigt den in Figur 3 mit IV-IV bezeichneten Schnitt durch das Siliziumsubstrat.
- Figur 5: zeigt den in Figur 3 mit V-V bezeichneten Schnitt durch das Siliziumsubstrat.
- Figur 6: zeigt eine Aufsicht auf das in Figur 3 dargestellte Siliziumsubstrat.

Die Darstellungen in den Figuren sind nicht maßstäblich.

Zur Herstellung einer erfindungsgemäßen Speicherzellenanordnung in einem Substrat 1 aus zum Beispiel monokristallinem Silizium wird zunächst an einer Hauptfläche 2 des Substrats 1 eine Isolationsstruktur erzeugt, die den Bereich für die Speicherzellenanordnung definiert (nicht dargestellt). Das Substrat 1 ist zum Beispiel p-dotiert mit einer Dotierstoffkonzentration von 10¹⁵ cm⁻³.

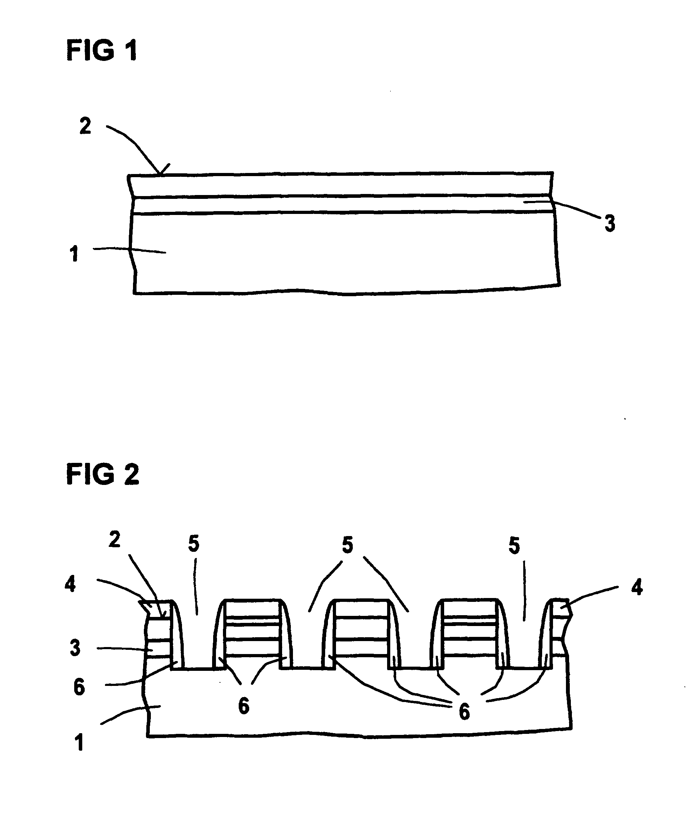

Anschließend wird eine Implantation mit Bor durchgeführt, zur Bildung einer Channel-Stop-Schicht 3. Die Borimplantation erfolgt mit einer Dosis von zum Beispiel 6 x 10¹³ cm⁻² und einer Energie von zum Beispiel 120 keV. Dadurch wird die Channel-Stop-Schicht 3 in einer Tiefe von zum Beispiel 0,2 µm unterhalb der Hauptfläche 2 in einer Dicke von 0,3 µm hergestellt (siehe Figur 1). Es wird eine erste Kanalimplantation mit zum Beispiel 1,5 x 10¹² cm⁻² bei 25 keV zur Einstellung der Einsatzspannungen von an der Hauptfläche herzustellenden MOS-Transistoren durchgeführt.

Nach Abscheidung einer SiO₂-Schicht in einer Dicke von zum Beispiel 200 nm mit Hilfe eines TEOS-Verfahrens wird durch Strukturierung der SiO₂-Schicht mit Hilfe photolithographischer Verfahren eine Grabenmaske 4 gebildet (siehe Figur 2).

Durch anisotropes Ätzen zum Beispiel mit Cl₂ werden unter Verwendung der Grabenmaske 4 als Ätzmaske Längsgräben 5 geätzt. Die Längsgräben 5 weisen eine Tiefe von zum Beispiel 0,6 µm auf. Die Längsgräben 5 reichen bis in das Substrat 1 hinein, sie durchtrennen die Channel-Stop-Schicht 3.

Die Weite der Längsgräben 5 beträgt bei einer 0,4 µm-Technologie 0,4 µm, der Abstand benachbarter Längskanäle 5 beträgt ebenfalls 0,4 µm. Die Länge der Längsgräben 5 richtet sich nach der Größe der Speicherzellenanordnung und beträgt zum Beispiel 130 µm.

Es folgt eine zweite Kanalimplantation mit zum Beispiel 1,5 x 10¹² cm⁻² bei 25 keV zur Einstellung der Einsatzspannung von am Boden der Längsgräben herzustellenden MOS-Transistoren.

Durch Abscheidung einer weiteren SiO₂-Schicht in einem TEOS-Verfahren und anschließendes anisotropes Ätzen werden an den Seitenwänden der Längsgräben 5 Spacer 6 aus SiO₂ gebildet.

Anschließend wird die Grabenmaske 4 naßchemisch zum Beispiel mit NH₄F/HF entfernt. Dabei werden auch die Spacer 6 entfernt. Nach Aufwachsen und Wegätzen eines Sacrificial-Oxids wird in einem TEOS-Verfahren eine weitere SiO₂-Schicht abgeschieden, aus der durch anisotropes Trockenätzen an den Seitenwänden der Längsgräben 5 wiederum Spacer 8 aus SiO₂ gebildet werden. Die SiO₂-Schicht wird in einer Dicke von zum Beispiel 60 nm abgeschieden. Das Rückätzen erfolgt zum Beispiel mit CF₄.

Anschließend wird ein Gatedielektrikum 7 gebildet. Das Gatedielektrikum 7 wird aus einem Material mit hoher Haftstellendichte für in das Dielektrikum injizierte Ladungsträger gebildet. Das Gatedielektrikum 7 wird zum Beispiel aus einer dielektrischen Mehrfachschicht gebildet, in der mindestens eine Schicht vorgesehen ist, die im Vergleich mit mindestens einer weiteren Schicht in der Mehrfachschicht einen erhöhten Ladungsträgereinfangquerschnitt aufweist. Vorzugsweise umfaßt die dielektrische Mehrfachschicht eine SiO₂-Schicht, eine Si₃N₄-Schicht und eine SiO₂-Schicht (sogenanntes ONO). Die Schichtdicken in der Mehrfachschicht werden so bemessen, daß die Mehrfachschicht bezüglich der Gatekapazität einer Schicht aus thermischem SiO₂ mit einer Dicke von zum Beispiel 10 nm entspricht. Dazu sind für die SiO₂- Schichten Schichtdicken jeweils von 4 nm und für die Si₃N₄-Schicht eine Schichtdicke von 5 nm erforderlich.

Alternativ kann das Gatedielektrikum 7 als Mehrfachschicht aus anderen Materialien, wobei die Schicht mit dem erhöhten Ladungsträgereinfangquerschnitt zum Beispiel aus Si₃N₄, Ta₂O₅, Al₂O₃ oder aus TiO₂ besteht und die benachbarte Schicht aus SiO₂, Si₃N₄ oder Al₂O₃ bestehen. Ferner kann das Gatedielektrikum 7 eine dielektrische Schicht, zum Beispiel aus SiO₂ umfassen, in die Fremdatome , zum Beispiel W, Pt, Cr, Ni, Pd, oder Ir eingelagert sind. Die eingelagerten Fremdatome können durch Implantation, durch Zugabe bei einer Oxidation oder Diffusion eingebracht werden.

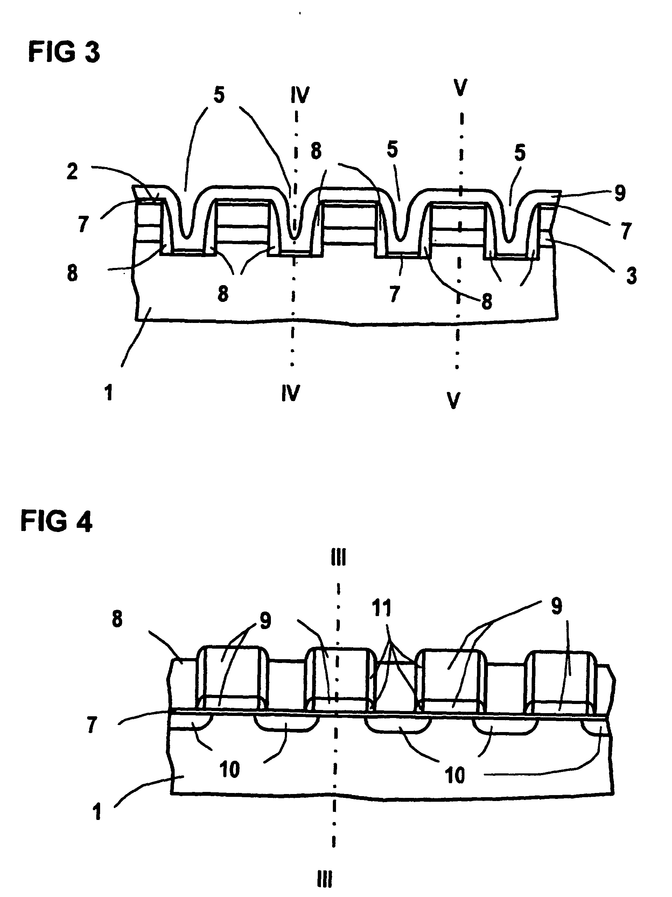

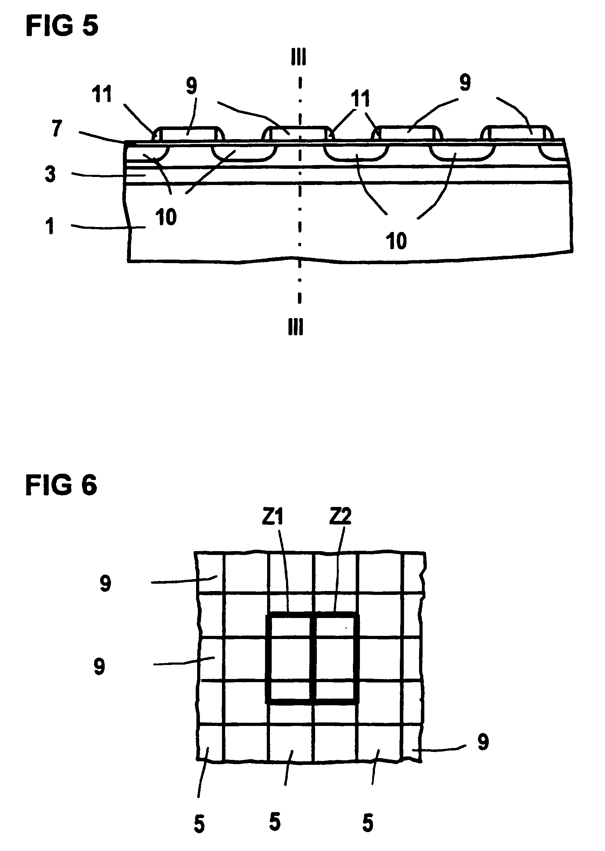

Das Gatedielektrikum 7 ist am Boden der Längsgräben 5 und zwischen den Längsgräben 5 auf der Hauptfläche 2 angeordnet (siehe Figur 3, Figur 4, der den mit IV-IV bezeichneten Schnitt durch Figur 3 darstellt, und Figur 5, die den mit V-V bezeichneten Schnitt in Figur 3 darstellt. Der in Figur 3 dargestellte Schnitt ist in Figur 4 und Figur 5 jeweils mit III-III bezeichnet).

Es wird ganzflächig eine Polysiliziumschicht in einer Dicke von zum Beispiel 400 nm abgeschieden. Durch Strukturierung der Polysiliziumschicht in einem photolithographischen Prozeßschritt werden Wortleitungen 9 gebildet, die entlang der Hauptfläche 2 zum Beispiel senkrecht zu den Längsgräben 5 verlaufen. Die Wortleitungen 9 weisen eine Breite von 0,4 µm auf. Benachbarte Wortleitungen 9 weisen einen Abstand von 0,4 µm auf. Breite und Abstand der Wortleitungen 9 entspricht jeweils einer minimalen Strukturgröße F.

Anschließend wird eine Source/Drain-Implantation mit zum Beispiel Arsen bei einer Energie von zum Beispiel 25 keV und einer Dosis von zum Beispiel 5 x 10¹⁵ cm⁻² durchgeführt. Bei der Source/Drain-Implantation werden am Boden der Längsgräben 5 sowie in der Hauptfläche 2 zwischen den Längsgräben 5 dotierte Gebiete 10 erzeugt. Die dotierten Gebiete 10 wirken jeweils als gemeinsames Source/Drain-Gebiet für zwei entlang einer Zeile angeordnete, benachbarte MOS-Transistoren. Bei der Source/Drain-Implantation werden gleichzeitig die Wortleitungen 9 dotiert.

Durch Abscheiden und anisotropes Rückätzen einer weiteren SiO₂-Schicht werden die Flanken der Wortleitungen 9 mit Spacern 11 bedeckt. Die Source/Drain-Implantation erfolgt selbstjustiert bezüglich der Wortleitungen 9. Entsprechend dem Abstand benachbarter Wortleitungen 9, dem Abstand benachbarter Längsgräben 5 sowie den Abmessungen der Längsgräben 5 beträgt die Fläche der dotierten Gebiete 10 parallel zur Hauptfläche 2 maximal F x F, das heißt 0,4 µm x 0,4 µm. Je zwei benachbarte dotierte Gebiete 10 und die dazwischen angeordnete Wortleitung 9 bilden jeweils einen MOS-Transistor. Am Boden der Längsgräben 5 sowie zwischen den Längsgräben 5 ist jeweils eine Zeile von in Reihe verschalteten MOS-Transistoren, die jeweils aus zwei dotierten Gebieten 10 und der dazwischen angeordneten Wortleitung 9 gebildet sind, angeordnet. Die am Boden eines Längsgrabens 5 angeordneten MOS-Transistoren sind von den benachbarten, zwischen den Längsgräben 5 angeordneten MOS-Transistoren durch den Spacer 8 und die Channel-Stop-Schicht 3 isoliert. Die Dotierung der Channel-Stop-Schicht 3 von zum Beispiel 3 x 10¹⁸ cm⁻³ gewährleistet gemeinsam mit den Spacern 8, daß die Schwellenspannung des an den Flanken der Längsgräben 5 gebildeten, parasitären MOS-Transistoren ausreichend hoch ist, um einen Leckstrom zu unterbinden.

Jede Zeile ist am Rand der Speicherzellenanordnung mit zwei Anschlüssen versehen, zwischen denen die in der Zeile angeordneten MOS-Transistoren in Reihe verschaltet sind (nicht dargestellt).

Berücksichtigt man, daß jedes der dotierten Gebiete 10 Source/Drain-Gebiet für zwei angrenzende MOS-Transistoren ist, so beträgt die Länge jedes MOS-Transistors parallel zum Verlauf der Längsgräben 5 2F. Die Breite der MOS-Transistoren beträgt jeweils F. Herstellungsbedingt beträgt die Fläche für eine aus einem MOS-Transistor gebildete Speicherzelle daher 2 F². Entlang einer Wortleitung 9 benachbarte Speicherzellen, deren Konturen Z1, Z2 in der Aufsicht in Figur 6 als verstärkte Linie eingezeichnet sind, grenzen in der Projektion auf die Hauptfläche 2 unmittelbar aneinander. Die Speicherzelle Z1 ist am Boden eines der Längsgräben 5 angeordnet, die Speicherzelle Z2 dagegen auf der Hauptfläche 2 zwischen zwei benachbarten Längsgräben 5. Durch die in der Höhe versetzte Anordnung benachbarter Speicherzellen wird die Packungsdichte erhöht, ohne daß die Isolation zwischen benachbarten Speicherzellen verschlechtert würde.

Die Programmierung der Speicherzellenanordnung erfolgt durch Füllen von Haftstellen im Gatedielektrikum 7 mittels Injektion von Elektronen. Dadurch wird die Schwellenspannung der programmierten MOS-Transistoren erhöht. Der jeweilige Wert der Schwellenspannungserhöhung läßt sich über Zeit und Größe der angelegten Spannung während der Programmierung einstellen.

Die Programmierung der Speicherzellenanordnung kann sowohl durch Fowler-Nordheim-Tunneln von Elektronen als auch durch Hot-Electron Injection erfolgen.

Zum Einschreiben der Information durch Fowler-Nordheim-Tunnel wird die zu programmierende Speicherzelle über die zugehörige Wortleitung 9 und Bitleitung ausgewählt. Als Bitleitung wirken in diesem Ausführungsbeispiel die entlang einer Zeile in Reihe geschalteten MOS-Transistoren. Die Bitleitung der Speicherzelle wird auf niedriges Potential gelegt, zum Beispiel auf 0 Volt. Die zugehörige Wortleitung 9 wird dagegen auf hohes Potential gelegt, zum Beispiel auf Vₚᵣ = 12 Volt. Die anderen Bitleitungen werden auf ein Potential V_{BL} angehoben, das so bemessen wird, daß Vₚᵣ - V_{BL} deutlich unterhalb der Programmierspannung Vₚᵣ liegt. Die anderen Wortleitungen 9 werden auf ein Potential V_{WL} größer gleich V_{BL} + V_{T} angehoben, wobei V_{T} die Schwellenspannung bedeutet. Da sich bei der Programmierung alle anderen Bitleitungen, die die ausgewählte Wortleitung kreuzen, auf höherem Potential befinden, werden die anderen Speicherzellen, die mit der ausgewählten Wortleitung verbunden sind, nicht programmiert. Die Speicherzellen sind in einer NAND-Konfiguration verschaltet. Sie können daher so beschaltet werden, daß kein Drainstrom durch die Speicherzellen fließt. Das hat den Vorteil, daß der gesamte Programmiervorgang sehr leistungsarm verläuft.

Erfolgt die Programmierung durch Hot-Electron-Injection, so muß an den zu programmierenden MOS-Transistor die Sättigungsspannung angelegt werden. Dazu wird die der Speicherzelle zugeordnete Bitleitung zwischen Erdpotential und ein hohes Potential, zum Beispiel V_{BLpr} = 6 Volt gelegt. Die der Speicherzelle zugeordnete Wortleitung wird auf ein Potential gelegt, bei dem sich der MOS-Transistor im Sättigungsbetrieb befindet. Die Spannung V_{WLpr} an der Wortleitung ist kleiner als V_{BLpr}, zum Beispiel V_{WLpr} = 4 Volt. Die anderen Wortleitungen werden auf ein hohes Potential gelegt, das höher ist als V_{BLpr} und V_{WLpr}, zum Beispiel V_{WL} = 7 Volt. Diese Spannung wird in Abhängigkeit von der Dicke des Gatedielektrikums 7 so gewählt, daß noch kein Fowler-Nordheim-Tunneln auftritt. Alle anderen Bitleitungen werden an beiden Enden auf gleiches Potential, zum Beispiel auf V_{BL} = V_{WLpr}/2 gelegt. Damit wird eine Programmierung von Speicherzellen, die entlang der ausgewählten Wortleitung an anderen Bitleitungen liegen, unterbunden und ein Stromfluß vermieden. Durch den Sättigungsbetrieb bei hoher Spannung entstehen im Kanalbereich des MOS-Transistors der ausgewählten Speicherzelle heiße Elektronen, die teilweise in das Gatedielektrikum 7 injiziert werden. Die Elektronen werden von Haftstellen im Gatedielektrikum 7 festgehalten und erhöhen die Schwellenspannung des MOS-Transistors. Je nach in der jeweiligen Speicherzelle einzuspeichernder Information wird auf diese Weise die Schwellenspannung des jeweiligen MOS-Transistors gezielt verändert.

Die Speicherzellenanordnung wird durch Abscheidung eines Zwischenoxids, Kontaktlochätzungen und Aufbringen und Strukturieren einer Metallschicht fertiggestellt. Diese bekannten Prozeßschritte sind nicht dargestellt.

## Patentansprüche

1. Elektrisch programmierbare Speicherzellenanordnung,
- bei der eine Vielzahl einzelner Speicherzellen in einem Halbleitersubstrat (1) vorgesehen sind,
- bei der die Speicherzellen jeweils in im wesentlichen parallel verlaufenden Zeilen angeordnet sind,
- bei der in einer Hauptfläche (2) des Halbleitersubstrats (1) Längsgräben (5) vorgesehen sind, die im wesentlichen parallel zu den Zeilen verlaufen,
- bei der die Zeilen jeweils abwechselnd auf der Hauptfläche (2) zwischen benachbarten Längsgräben (5) und auf dem Boden der Längsgräben (5) angeordnet sind,
- bei der Isolationsstrukturen (3, 8) vorgesehen sind, die benachbarte Zeilen gegeneinander isolieren,
- bei der die Speicherzellen jeweils mindestens einen MOS-Transistor (10, 9, 10) umfassen,
- bei der quer zu den Zeilen Wortleitungen (9) verlaufen, die jeweils mit den Gateelektroden von entlang unterschiedlichen Zeilen angeordneten MOS-Transistoren verbunden sind, und
- bei der die MOS-Transistoren eine dielektrische Schicht als Gatedielektrikum (7) aufweisen,
**dadurch gekennzeichnet, dass**
der Ladungsträgereinfangquerschnitt des Gatedielektrikums (7) durch eine weitere Schicht mit erhöhten Ladungsträgereinfangquerschnitt oder durch in die dielektrische Schicht eingelagerte Fremdatome erhöht ist.

2. Speicherzellenanordnung nach Anspruch 1,
bei der die Isolationsstrukturen zur Isolation benachbarter Zeilen entlang den Seitenwänden der Längsgräben (5) angeordnete, isolierende Spacer (8) und jeweils zwischen benachbarten Längsgräben (5) im Halbleitersubstrat (1) angeordnete, dotierte Schichten (3) umfassen, die die Ausbildung leitender Kanäle im Halbleitersubstrat (1) zwischen benachbarten Zeilen verhindern.

3. Speicherzellenanordnung nach Anspruch 1 oder 2,
- bei der die MOS-Transistoren von entlang einer Zeile angeordneten Speicherzellen in Reihe verschaltet sind,
- bei der miteinander verbundene Source/Drain-Gebiete von entlang einer Zeile benachbarten MOS-Transistoren als zusammenhängendes dotiertes Gebiet (10) im Halbleitersubstrat ausgebildet sind,
- bei der jede Zeile zwei Anschlüsse aufweist, zwischen denen die in der Zeile angeordneten MOS-Transistoren in Reihe verschaltet sind.

4. Speicherzellenanordnung nach einem der Ansprüche 1 bis 3, bei der die MOS-Transistoren als Gatedielektrikum (7) eine dielektrische Mehrfachschicht umfassen mit mindestens einer Schicht, die im Vergleich mit mindestens einer weiteren Schicht einen erhöhten Ladungsträgereinfangsquerschnitt aufweist.

5. Speicherzellenanordnung nach Anspruch 4,
- bei der die Schicht mit erhöhtem Ladungsträgereinfangsquerschnitt mindestens einen der Stoffe Si₃N₄, Ta₂O₅, Al₂O₃ oder TiO₂ umfaßt,
- bei der die weitere Schicht mindestens einen der Stoffe SiO₂, Si₃N₄ oder Al₂O₃ umfaßt

6. Speicherzellenanordnung nach einem der Ansprüche 1 bis 3, bei der die MOS-Transistoren als Gatedielektrikum (7) eine dielektrische Schicht mit eingelagerten Fremdatomen umfassen, wobei die eingelagerten Fremdatome im Vergleich mit der dielektrischen Schicht einen erhöhten Ladungsträgereinfangsquerschnitt aufweisen.

7. Speicherzellenanordnung nach Anspruch 6,
- bei der die dielektrische Schicht SiO₂ umfaßt,
- bei der die eingelagerten Fremdatome mindestens eines der Elemente W, Pt, Cr, Ni, Pd, oder Ir enthalten.

8. Verfahren zur Herstellung einer elektrisch programmierbaren Speicherzellenanordnung,
- bei dem in einer Hauptfläche (2) eines Halbleitersubstrats (1) im wesentlichen parallel verlaufende Längsgräben (5) geätzt werden,
- bei dem eine Vielzahl in Zeilen angeordneter Speicherzellen, die jeweils mindestens einen MOS-Transistor umfassen, erzeugt werden, wobei die Zeilen abwechselnd an der Hauptfläche (2) zwischen benachbarten Längsgräben (5) und am Boden der Längsgräben (5) angeordnet sind,
- bei dem eine dielektrische Schicht als Gatedielektrikum (7) erzeugt wird,
- bei dem quer zu den Zeilen verlaufende Wortleitungen (9) erzeugt werden, die jeweils mit Gateelektroden von entlang unterschiedlichen Zeilen angeordneten MOS-Transistoren verbunden sind,
- bei dem eine Source/Drain-Implantation für die MOS-Transistoren durchgeführt wird, bei der die Wortleitungen (9) als Maske verwendet werden,
- bei dem Isolationsstrukturen (3, 8) erzeugt werden, die die MOS-Transistoren benachbarter Zeilen gegeneinander isolieren,
**dadurch gekennzeichnet , dass**
der Ladungsträgereinfangquerschnitt des Gatedielektrikums (7) durch Herstellen einer weiteren Schicht mit erhöhtenladungsträgereinfangquerschnitt oder durch Einlagern von Fremdatomen in die dielektrische Schicht erhöht ist.

9. Verfahren nach Anspruch 8,
- bei dem zur Bildung der Isolationsstrukturen im Halbleitersubstrat (1) eine dotierte Schicht (3) erzeugt wird, die beim Ätzen der Längsgräben (5) durchätzt wird und die die Ausbildung leitender Kanäle im Halbleitersubstrat (1) zwischen benachbarten Zeilen verhindert,
- bei dem zur Bildung der Isolationsstrukturen (3, 8) ferner nach dem Ätzen der Längsgräben (5) an den Seitenwänden der Längsgräben (5) isolierende Spacer (8) erzeugt werden.

10. Verfahren nach Anspruch 8 oder 9, -
bei dem das Gatedielektrikum (7) als Mehrfachschicht mit mindestens einer Schicht, die im Vergleich mit der dielektrischen Schicht einen erhöhten Ladungsträgereinfangquerschnitt aufweist, gebildet wird.

11. Verfahren nach Anspruch 10,
- bei dem die Schicht mit erhöhtem Ladungsträgereinfangquerschnitt mindestens einen der Stoffe Si₃N₄, Ta₂O₅, Al₂O₃ oder TiO₂ umfaßt,
- bei dem die dielektrische Schicht mindestens einen der Stoffe SiO₂, Si₃N₄ oder Al₂O₃ umfaßt

12. Verfahren nach Anspruch 8 oder 9,
bei dem das Gatedielektrikum (7) als dielektrische Schicht mit eingelagerten Fremdatomen gebildet wird, wobei die eingelagerten Fremdatome im Vergleich mit der dielektrischen Schicht einen erhöhten Ladungsträgereinfangsquerschnitt aufweisen.

13. Verfahren nach Anspruch 12,
- bei dem die dielektrische Schicht SiO₂ umfaßt,
- bei dem die eingelagerten Fremdatome mindestens eines der Elemente W, Pt, Cr, Ni, Pd, oder Ir enthalten.

## Claims

1. Electrically programmable memory cell arrangement,
- in which a multiplicity of individual memory cells are provided in a semiconductor substrate (1),
- in which the memory cells are arranged in each case in rows running essentially parallel,
- in which longitudinal trenches (5) which run essentially parallel to the rows are provided in a main area (2) of the semiconductor substrate (1),
- in which the rows are arranged in each case alternately on the main area (2) between adjacent longitudinal trenches (5) and on the bottom of the longitudinal trenches (5),
- in which insulation structures (3, 8) which insulate adjacent rows from one another are provided,
- in which the memory cells in each comprise at least one MOS transistor (10, 9, 10),
- in which word lines (9) run transversely with respect to the rows and are each connected to the gate electrodes of MOS transistors arranged along different rows,
and
- in which the MOS transistors have a dielectric layer as gate dielectric (7), **characterized in that** the charge carrier capture cross-section of the gate dielectric (7) is increased by a further layer with an increased charge carrier capture cross-section or by impurities which are incorporated into the dielectric layer.

2. Memory cell arrangement according to Claim 1,
in which the insulation structures for the insulation of adjacent rows comprise insulating spacers (8), which are arranged along the side walls of the longitudinal trenches (5), and doped layers (3), which are arranged in each case between adjacent longitudinal trenches (5) in the semiconductor substrate (1) and prevent the formation of conductive channels in the semiconductor substrate (1) between adjacent rows.

3. Memory cell arrangement according to Claim 1 or 2,
- in which the MOS transistors of memory cells arranged along a row are connected up in series,
- in which interconnected source/drain regions of MOS transistors which are adjacent along a row are designed as a coherent doped region (10) in the semiconductor substrate,
- in which each row has two terminals, between which the MOS transistors arranged in the row are connected up in series.

4. Memory cell arrangement according to one of Claims 1 to 3,
in which the MOS transistors comprise, as the gate dielectric (7), a dielectric multiple layer having at least one layer which has an increased charge carrier capture cross-section in comparison with at least one further layer.

5. Memory cell arrangement according to Claim 4,
- in which the layer having an increased charge carrier capture cross-section comprises at least one of the substances Si₃N₄, Ta₂O₅, Al₂O₃ or TiO₂,
- in which the further layer comprises at least one of the substances SiO₂, Si₃N₄ or Al₂O₃.

6. Memory cell arrangement according to one of Claims 1 to 3,
in which the MOS transistors comprise, as the gate dielectric (7), a dielectric layer having incorporated impurities, the incorporated impurities having an increased charge carrier capture cross-section in comparison with the dielectric layer.

7. Memory cell arrangement according to Claim 6,
- in which the dielectric layer comprises SiO₂,
- in which the incorporated impurities contain at least one of the elements W, Pt, Cr, Ni, Pd or Ir.

8. Method for producing an electrically programmable memory cell arrangement,
- in which longitudinal trenches (5) running essentially parallel are etched in a main area (2) of a semiconductor substrate (1),
- in which a multiplicity of memory cells which are arranged in rows and each comprise at least one MOS transistor are produced, the rows being arranged alternately on the main area (2) between adjacent longitudinal trenches (5) and on the bottom of the longitudinal trenches (5),
- in which a dielectric layer is produced as gate dielectric (7),
- in which word lines (9) which run transversely with respect to the rows and are each connected to gate electrodes of MOS transistors arranged along different rows are produced,
- in which a source/drain implantation for the MOS transistors is carried out, during which the word lines (9) are used as a mask,
- in which insulation structures (3, 8) which insulate the MOS transistors of adjacent rows from one another are produced, **characterized in that** the charge carrier capture cross-section of the gate dielectric (7) is increased by producing a further layer with an increased charge carrier capture cross-section or by incorporating impurities into the dielectric layer.

9. Method according to Claim 8,
- in which, in order to form the insulation structures in the semiconductor substrate (1), a doped layer (3) is produced which is etched through when the longitudinal trenches (5) are etched and which prevents the formation of conductive channels in the semiconductor substrate (1) between adjacent rows,
- in which, in order to form the insulation structures (3, 8), insulating spacers (8) are furthermore produced on the side walls of the longitudinal trenches (5) after the longitudinal trenches (5) have been etched.

10. Method according to Claim 8 or 9,
- in which the gate dielectric (7) is formed as a multiple layer having at least one layer which has an increased charge carrier capture cross-section in comparison with the dielectric layer.

11. Method according to Claim 10,
- in which the layer having an increased charge carrier capture cross-section comprises at least one of the substances Si₃N₄, Ta₂O₅, Al₂O₃ or TiO₂,
- in which the dielectric layer comprises at least one of the substances SiO₂, Si₃N₄ or Al₂O₃.

12. Method according to Claim 8 or 9,
in which the gate dielectric (7) is formed as a dielectric layer having incorporated impurities, the incorporated impurities having an increased charge carrier capture cross-section in comparison with the dielectric layer.

13. Method according to Claim 12,
- in which the dielectric layer comprises SiO₂,
- in which the incorporated impurities contain at least one of the elements W, Pt, Cr, Ni, Pd or Ir.

## Revendications

1. Dispositif de cellules de mémoire programmable électriquement,
- dans lequel il est prévu une pluralité de cellules de mémoire dans un substrat (1) semi-conducteur,
- dans lequel les cellules de mémoire sont disposées respectivement en des lignes sensiblement parallèles,
- dans lequel il est prévu, dans une surface (2) principale du substrat (1) semi-conducteur, des sillons (5) longitudinaux qui sont sensiblement parallèles aux lignes,
- dans lequel les lignes sont disposées respectivement en alternance sur la surface (2) principale entre des sillons (5) longitudinaux voisins et sur le fond des sillons (5) longitudinaux,
- dans lequel il est prévu des structures (3, 8) isolantes qui isolent les unes des autres des lignes voisines,
- dans lequel les cellules de mémoire comprennent respectivement au moins un transistor (10, 9, 10) MOS,
- dans lequel s'étendent, tranversalement aux lignes, des lignes (9) de mots qui sont reliées respectivement aux électrodes de grille de transistors MOS disposés le long de lignes différentes, et
- dans lequel les transistors MOS ont une couche diélectrique comme diélectrique (7) de grille,
**caractérisé en ce que** la section de capture dé porteurs de charge du diélectrique (7) de grille est rendue plus grande par une autre couche de section de capture de porteurs de charge plus grande ou par des atomes étrangers incorporés dans la couche diélectrique.

2. Dispositif de cellules de mémoire suivant la revendication 1,
dans lequel les structures isolantes pour isoler des lignes voisines comprennent des espaceurs (8) isolants disposés le long des parois latérales des sillons (5) longitudinaux, des couches (3) dopées et disposées respectivement entre des sillons (5) longitudinaux voisins dans le substrat (1) semi-conducteur, qui empêchent la constitution de canaux conducteurs dans le substrat (1) semi-conducteur entre des lignes voisines.

3. Dispositif de cellules de mémoire suivant la revendication 1 ou 2,
- dans lequel les transistors MOS de cellules de mémoire disposées le long d'une ligne sont montés en série,
- dans lequel les zones de source/drain reliées entre elles de transistors MOS voisins le long d'une ligne sont constituées dans le substrat semi-conducteur sous la forme de zones (10) dopées d'un seul tenant,
- dans lequel chaque ligne a deux bornes entre lesquelles les transistors MOS disposés dans les lignes sont montés en série.

4. Dispositif de cellules de mémoire suivant l'une des revendications 1 à 3, dans lequel les transistors MOS comprennent comme diélectrique (7) de grille une couche diélectrique multiple ayant au moins une couche, qui ont une section de capture de porteurs de charge plus grande que celle de l'au moins une autre couche.

5. Dispositif de cellules de mémoire suivant la revendication 4,
- dans lequel la couche ayant une section transversale de capture de porteurs de charge augmentée comprend au moins l'une des substances Si₃N₄, Ta₂O₅, Al₂O₃ ou TiO₂,
- dans lequel l'autre couche comprend au moins l'une des substances SiO₂, Si₃N₄ ou Al₂O₃.

6. Dispositif de cellules de mémoire suivant l'une des revendications 1 à 3, dans lequel les transistors MOS comprennent comme diélectrique (7) de grille une couche diélectrique ayant des atomes étrangers incorporés, les atomes étrangers incorporés ayant une section de capture de porteurs de charge plus grande que celle de la couche diélectrique.

7. Dispositif de cellules de mémoire suivant la revendication 6,
- dans lequel la couche diélectrique comprend du SiO₂,
- dans lequel les atomes étrangers incorporés comprennent au moins l'un des éléments W, Pt, Cr, Ni, Pd ou Ir.

8. Procédé de production d'un dispositif de cellules de mémoire programmable électriquement,
- dans lequel on ménage par attaque dans une surface (2) principale d'un substrat (1) semi-conducteur des sillons (5) longitudinaux sensiblement parallèles,
- dans lequel on produit une pluralité de cellules de mémoire qui sont disposées en ligne et qui ont respectivement au moins un transistor MOS, les lignes étant disposées en alternance sur la surface (2) principale entre des sillons (5) longitudinaux voisins et sur le fond des sillons (5) longitudinaux,
- dans lequel on produit une couche diélectrique en tant que diélectrique (7) de grille,
- dans lequel on produit des lignes (9) de mots qui s'étendent transversalement aux lignes et qui sont reliées respectivement à des électrodes de grille de transistors MOS disposés le long de lignes différentes,
- dans lequel on effectue l'implantation de source/drain pour les transistors MOS en utilisant les lignes (9) de mots comme masque,
- dans lequel on produit des structures (3, 8) isolantes qui isolent les uns des autres les transistors MOS de lignes voisines,
**caractérisé en ce que** la section de capture de porteurs de charge du diélectrique (7) de grille est rendue plus grande par une autre couche de section de capture de porteurs de charge plus grande ou par des atomes étrangers incorporés dans la couche diélectrique.

9. Procédé suivant la revendication 8,
- dans lequel on produit, pour former les structures isolantes dans le substrat (1) semi-conducteur, une couche (3) dopée que l'on traverse lorsque l'on ménage par attaque les sillons (5) longitudinaux et qui empêche la formation de canaux conducteurs dans le substrat (1) semi-conducteur entre des lignes voisines,
- dans lequel, pour former les structures (3, 8) isolantes, on produit en outre, après avoir ménagé par attaque les sillons (5) longitudinaux, des espaceurs (8) isolants sur les parois latérales des sillons (5) longitudinaux.

10. Procédé suivant la revendication 8 ou 9, dans lequel on forme le diélectrique (7) de grille sous la forme d'une couche multiple ayant au moins une couche qui a une section de capture de porteurs de charge plus grande que celle de la couche diélectrique.

11. Procédé suivant la revendication 10,
- dans lequel la couche ayant une section transversale de capture de porteurs de charge augmentée comprend au moins l'une des substances Si₃N₄, Ta₂O₅, Al₂O₃ ou TiO₂,
- dans lequel l'autre couche comprend au moins l'une des substances SiO₂, Si₃N₄ ou Al₂O₃.

12. Procédé suivant la revendication 8 ou 9, dans lequel on forme le diélectrique (7) de grille sous la forme d'une couche diélectrique ayant des atomes étrangers incorporés, les atomes étrangers incorporés ayant une section de capteur de porteurs de charge plus grande que celle de la couche électrique.

13. Procédé suivant la revendication 12,
- dans lequel la couche diélectrique comprend du SiO₂,
dans lequel les atomes étrangers incorporés comprennent au moins l'un des éléments W, Pt, Cr, Ni, Pd ou Ir.
